# EUROPEAN PATENT APPLICATION

(11) **EP 1 028 522 A1**
(43) Date of publication of application: **16.08.2000**
(21) Application number: 99200389.7
(22) Date of filing: 10.02.1999
(51) Int. Cl.: H03F 1/02, H03F 3/217

(54) **Communication device**

(71) Applicant: Semiconductor Ideas to The Market (ItoM) BV, 4839 AH Breda (NL)
(72) Inventor: Van Rumpt, Herman Wouter, 5253 HC 'S-Hertogenbosch (NL)
(74) Representative: Van Straaten, Joop

(57) **Abstract**

The invention relates to a communication device including a power amplifier for amplifying a modulated high frequency carrier signal comprising a resonance circuit arranged between resonance circuit input means and antenna means. To improve the power added efficiency of the power amplifier, the resonance circuit input means is provided with an excitation circuit for supplying an excitation signal to the resonance circuit phase and/or frequency coupled with the modulated high frequency carrier signal and having a duty cycle significantly less than 50%.

## Description

The invention relates to a communication device including a power amplifier for amplifying a modulated high frequency carrier input signal comprising a resonance circuit arranged between resonance circuit input means and antenna means.

A communication device including a power amplifier of the above type is known from the article "A 1.9 GHz 1 W CMOS Class E Power Amplifier for Wireless Communications" by King-Chun Tsai and Paul R. Gray, Department of Electrical Engineering and Computer Sciences, University of California, Berkeley, California, U.S.A., published in Proceedings of the 24^{th} European Solid-State Conference, The Hague, The Netherlands, 22-24 September 1998.

The resonance circuit of the known power amplifier comprises a tuned LC load network having an inductor and a capacitor serially arranged between a supply voltage terminal and mass, as well as a controllable switch connected across the capacitor. The switch being part of said resonance circuit input means is to shortcircuit the capacitor alternately during half period cycles of the carrier frequency, synchronised with the phase and/or frequency modulation of said high frequency carrier input signal. The tuned load network is designed such with regard to the operation of the switch, that in steady state, the voltage across the capacitor crosses zero level, immediately before the switch is closed. The common node between the capacitor and the inductor is connected to a bandpass filter to select the fundamental component of the voltage occurring across the capacitor, passing the information embedded in the modulation to the output with a power amplification.

According to the teaching of said article, ideally the switch would dissipate no power because it is closed when the voltage across the switch is zero. All of the DC supply power would therewith be delivered to the 6 output of the LC load network. A further optimization in the efficiency of the power amplifier would be achieved by proper design, aiming at an accurate half cycle periodic operation of the switch, which would a.o. result in the capacitor being fully discharged at the moment the switch is closed, and at steep switching transients.

However, communication devices have to keep up with ever increasing market demands. Power amplifiers are one of the key circuits basically determining the overall performance of such devices. For important applications within the field of telecommunication, the requirements put to power amplifiers in terms of power added efficiency and cost effectiveness already increased beyond the limits attainable with power amplifiers based on the above known principle.

An object of the invention is, therefore, to improve the performance of communication devices by providing a power amplifier based on a new principle having an efficiency, substantially greater than achievable with the above known power amplifier.

Another object of the invention is to provide a versatile power amplifier applicable in communication devices complying with a broad range of telecommunication standards.

Yet another object of the invention is to provide a communication device to great extent being suitable for an implementation in integrated form.

According to the invention a communication device including a power amplifier for amplifying a modulated high frequency carrier input signal comprising a resonance circuit arranged between resonance circuit input means and antenna means is therefore characterized in that the resonance circuit input means comprise an excitation circuit for a periodic excitation of the resonance circuit phase and/or frequency coupled with the modulated high frequency carrier signal and substantially occurring with a duty cycle less than 50%.

The invention is based on the recognition that extending the free running period of the resonance circuit beyond a half cycle period considerably reduces loss of resonance signal energy. The excitation energy needed to compensate for those losses can therefore be reduced as well, without affecting the amplifier output power. This results in an effective increase in the efficiency of the power amplifier.

The invention therewith cuts across the notion that decreasing the duty cycle of a resonance circuit input signal below 50% will lead to power loss due to spectral power spread inherent to any decrease in duty cycle.

The measure according to the invention provides a fundamental breakthrough beyond the efficiency limits of the known power amplifier, allowing to substantially improve the performance of communication devices.

In a preferred embodiment of such communication device, the excitation circuit comprises a charge pump supplying an excitation current signal to the resonance circuit phase and/or frequency coupled with the modulated carrier signal circuit having continuous transients between a minimum and a maximum current level, the excitation current signal exceeding 50% of the maximum current level during a periodic time interval smaller than 50% of the repetition time of the input signal.

The excitation current signal is used herein to directly compensate the above loss of signal energy, allowing to improve the accuracy of compensation and therewith the efficiency of the power amplifier.

To provide for a proper impedance and signal matching without using complex circuitry, the charge pump preferably comprises an output stage with a bipolar transistor, the collector emitter path thereof being serially coupled to the resonance circuit between first and second terminals of a supply voltage source.

Another preferred embodiment of a communication device according to the invention, is characterized in that the excitation circuit comprises a controllable switching device serially arranged with the resonance circuit between first and second terminals of a voltage supply source and having a control terminal coupled to the input of the power amplifier for periodically supplying an excitation voltage signal to the resonance circuit, phase and/or frequency coupled with the modulated carrier signal circuit with a duty cycle less than 50%.

When applying this measure the resonance signal losses in the resonance circuit are compensated by periodically applying the full supply voltage across the resonance circuit.

Preferably, the controllable switching device comprises a switch resistance serially arranged with the resonance circuit between the first and second terminals of said voltage supply source, being varied from a maximum resistance value to a minimum resistance value and vice versa and being smaller than 50% of the maximum resistance value during a periodic time interval smaller than 50% of the repetition time of the input signal.

In a further preferred embodiment the controllable switching device comprises a MOS transistor having its drain source path serially coupled to the resonance circuit and being controlled to vary the switch resistance continuously.

In the communication device according to the invention the excitation of the resonance circuit not only tracks modulation dependent phase and/or frequency deviations of the modulated high frequency carrier input signal, but also allows to amplify modulation dependent envelope amplitude variations of said input signal, if any. The extra degree of freedom provided herewith makes it possible to comply with various different telecommunication standards, including those using constant envelope modulated high frequency carrier signals (such as e.g. GSM) and those using modulated envelope high frequency carrier signals (such as e.g. CDMA).

When using an excitation circuit with a charge pump as indicated above, a preferred embodiment of a communication device complying with telecommunication standards using modulated envelope high frequency carrier signals comprises amplitude modulation means for modulating the excitation signal as well as a supply voltage coupled to the resonance circuit with modulation signal dependent envelope amplitude variations of the modulated high frequency carrier signal.

When using an excitation circuit with a controllable switching device as indicated above, such communication device preferably comprises amplitude modulation means for modulating the amplitude of the supply voltage between the first and second terminals of the voltage supply source with modulation signal dependent envelope amplitude variations of the modulated high frequency carrier signal.

In telecommunication standards using constant envelope modulated high frequency carrier signals the envelope amplitude of the excitation signal is kept constant.

Another preferred embodiment of a communication device according to the invention is characterized by said antenna means having narrow bandwidth and being part of the resonance circuit.

This measure allows to combine main part of the resonance circuit functionality with the functionality of the antenna means, therewith providing an extensive integration of the resonance circuit with the antenna means and reducing the number of elements needed.

Preferably the antenna impedance is coupled to a tap of the inductor of said parallel LC circuit, which removes the need for an antenna impedance transformer.

The above and other object features and advantages of the present invention will be discussed more in detail hereinafter with reference to the disclosure of preferred embodiments and in particular with reference to the appended Figures, that show:
- Figure 1: a blockdiagram of a communication device including a first embodiment of a power amplifier according to the invention;
- Figure 2: a blockdiagram of a second embodiment of a power amplifier according to the invention;
- Figures 3a-e: signal plots showing the effect of an excitation signal having a 50% duty cycle on the efficiency when used in the power amplifier of Figure 1, in which the excitation circuit is provided with a MOS transistor output stage;
- Figures 4a-e: signal plots showing the improvement in efficiency of the power amplifier when reducing the duty cycle of the excitation signal in the situation of Figure 3a-e, to 25%;
- Figures 5a-e: signal plots showing the effect of an excitation signal having a 50% duty cycle on the efficiency when used in the power amplifier of Figure 1, in which the excitation circuit is provided with a bipolar transistor output stage;
- Figures 6a-e: signal plots showing the improvement in efficiency of the power amplifier when reducing the duty cycle of the excitation signal in the situation of Figure 5a-e, to 25%;
- Figure 7a-c: various excitation signal forms usable in a communication device according to the invention;
- Figure 8 a-c: signal plots illustrating the functioning of the power amplifier according to the invention when being used to for amplifying an envelope amplitude modulated high frequency carrier signal.

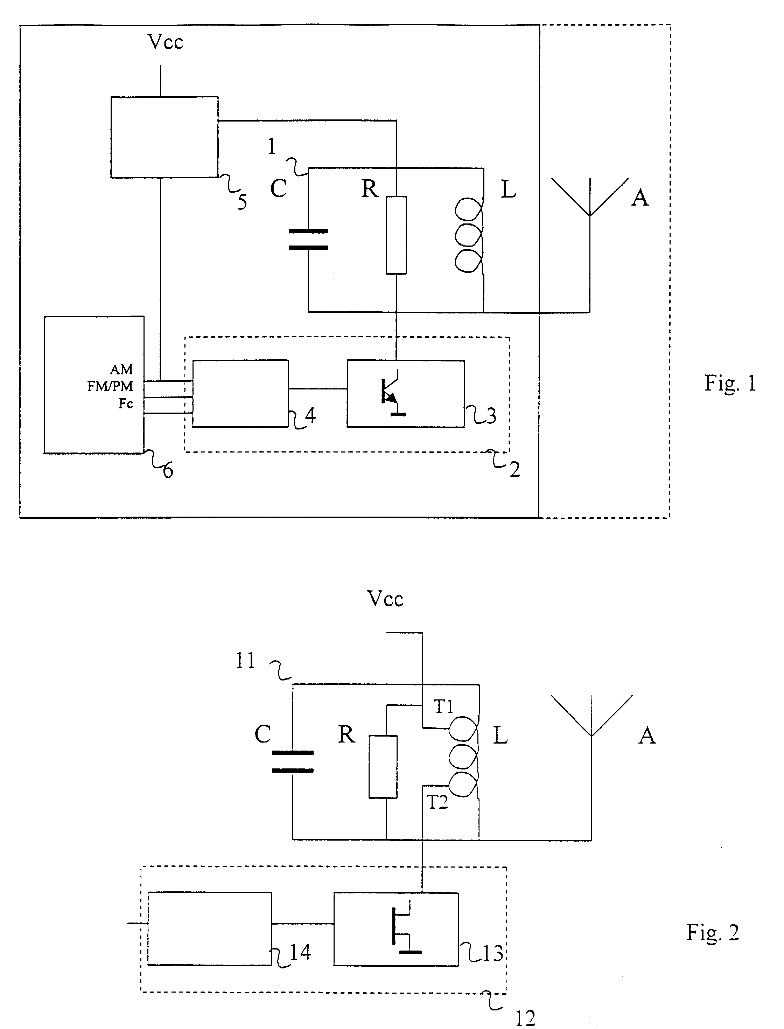

Figure 1 shows a blockdiagram of a communication device according to the invention, which is compliant to telecommunication standards using modulated envelope high frequency carrier signals (such as e.g. CDMA), including a power amplifier (1-5), preceded by a transmitter pre-stage unit 6 and followed by antenna means A. The transmitter pre-stage unit 6 is provided with an output supplying a high frequency carrier signal at a terminal Fc, a baseband modulation signal for modulating said high frequency carrier signal in phase and/or frequency at a terminal FM/PM, and a baseband modulation signal for modulating the envelope amplitude of said high frequency carrier signal at a terminal AM. With regard to the transmitter pre-stage unit 6 reference is made to existing prior art CDMA portable communication devices. Detailed knowledge of the transmitter pre-stage unit 6 is not needed to properly understand the invention, reason for which the unit 6 will not be further described.

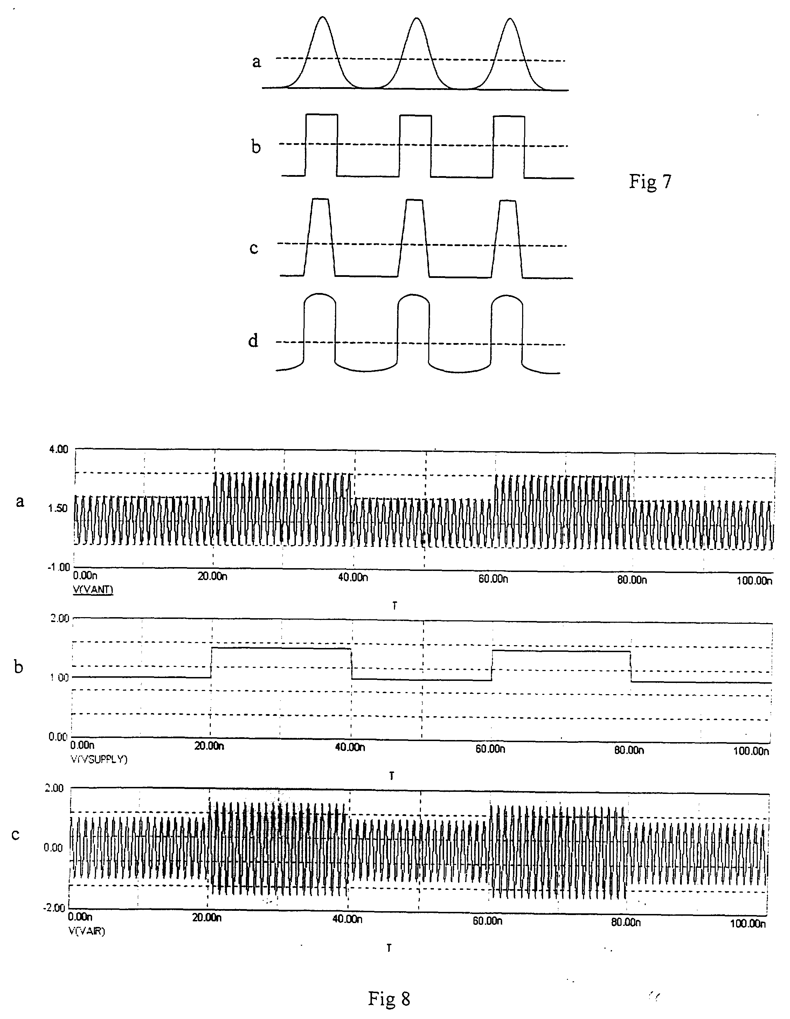

The power amplifier (1-5) comprises a resonance circuit 1 arranged between resonance circuit input means 2 and the antenna means A, the resonance circuit input means 2 comprising an excitation circuit 3 coupled between a pulse generator 4 and the resonance circuit 1 for supplying an excitation signal thereto. The baseband modulation signals at the terminals PM/FM and AM, hereinafter referred to as PM/FM and AM baseband modulation signals respectively, and the high frequency carrier signal at the terminal Fc of the transmitter pre-stage unit 6 are supplied to the pulse generator 4, which derives therefrom control signal pulses for the excitation circuit 3. These pulses do not refer to a specific signal form, as will be explained hereinafter in more detail with reference to Figure 8 and may be rectangular, sinusoidal, Gaussian or otherwise. The control signal pulses are generated at each period of the high frequency carrier signal phase and/or frequency modulated with the PM/FM baseband modulation signal with a duty cycle less than 50%. In addition thereto the pulse generator 4 also modulates the envelope amplitude of these control pulses with the AM baseband modulation signal. The circuitry needed to come to an excitation signal as defined hereabove, i.e. tracking the modulated high frequency carrier signal in its phase and/or frequency and/or amplitude and having a duty cycle less than 50%, can as such be designed and implemented by anyone skilled in the art to arrive at. In this connection, reference is made to Philips' pulse generator type PM 5786 B. The functionality of the pulse generator 4 may well be combined with the functionality of excitation circuit 3 in one single device.

The excitation circuit 3 comprises a charge pump with an output stage having a bipolar transistor, the collector emitter path thereof being serially coupled to the resonance circuit 1 between first and second terminals of a supply voltage source Vcc.

The resonance circuit 1 comprises a parallel RLC circuit directly coupled to the antenna means A. The resistor R represents mainly the radiation resistance of the antenna means A. The resonance frequency of the circuit 1 is chosen to correspond substantially to the carrier frequency of the modulated high frequency carrier signal. The quality factor Q of the resonance circuit is preferably chosen to be greater than 1.

Furthermore, if the antenna means A are dimensioned to have a narrow bandwidth, then such narrow bandwidth antenna means can provide the functionality of the parallel RLC circuit to a great part. This removes the need to use a completely equipped RLC circuit in the resonance circuit 1, allowing to integrate the antenna means A as part of the power amplifier (1-5).

The pulse generator 4 controls the excitation circuit 3 to generate an excitation signal following the control pulses in their phase and/or frequency and their envelope amplitude modulation, and having continuous transients between a minimum and a maximum current level, the excitation current signal exceeding 50% of the maximum current level during a periodic time interval smaller than 50% of the repetition time of the input signal. The excitation signal excitates the resonance circuit 1, therewith bringing this circuit in a resonance mode in accordance with the invention.

In addition thereto the supply voltage Vcc is amplitude modulated with the AM baseband modulation signal through an amplitude modulator 5, which is coupled to the terminal AM of the transmitter pre-stage unit 6. With regard to this amplitude modulator 5, reference is made to Philips' IC family type LM 78xx or equivalent ICs.

The functioning of the power amplifier with regard to AM modulations will be explained with reference to Figures 8a-c.

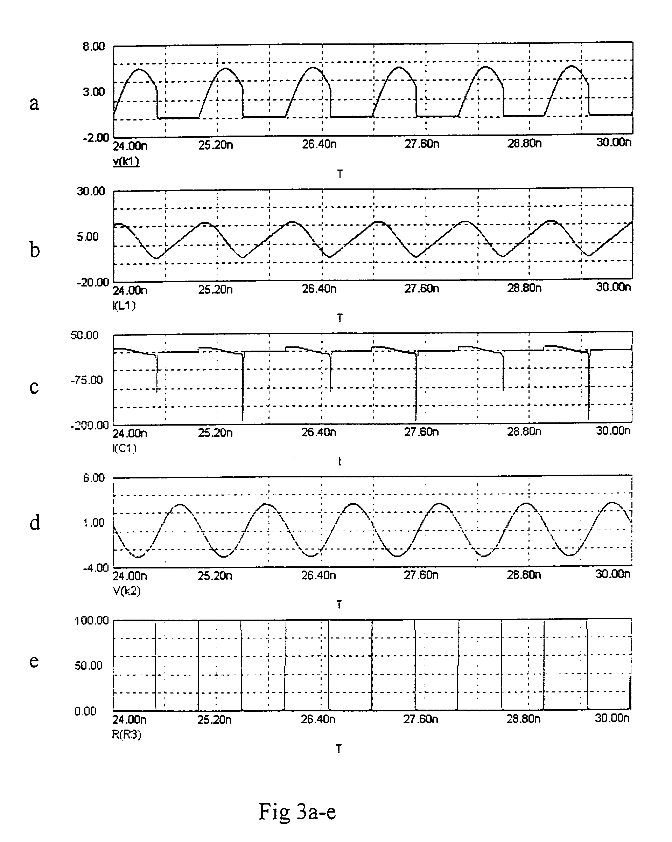

The effect of using a charge pump in the excitation circuit 3 and the reduction of the duty cycle of the excitation signal compared with the known power amplifier, will be explained with reference to Figures 3a-e, Figures 5a-e and Figures 6a-e.

Figure 2 shows a blockdiagram of a second embodiment of a power amplifier for use in a communication device according to the invention in which elements corresponding to those of Figure 1 have the same references. The excitation circuit 3 now comprises a switching device using a MOS transistor having its drain source path serially arranged with the resonance circuit 1 between first and second terminals of a supply voltage source, respectively connected to mass and a supply voltage Vcc. For AC signals both first and second terminals may be considered to be massconnected.

In the resonance circuit 1 the capacitor C is parallel connected to the inductor L, but unlike the resonance circuit of Figure 1, the inductor L is now provided with first and second taps, T1 respectively T2. The first tap T1 is coupled to the resistor R and the second supply voltage terminal, the second tap T2 is coupled to the output of the excitation circuit 3, therewith therewith providing proper antenna impedance matching without using an extra impedance transformer.

Figures 3a-d show in respective signalplots a to e the variation over time of signals measured at certain points in the power amplifier of Figure 1 when using a MOS transistor as a switch device in the excitation circuit 3, the drain source path thereof being serially connected between mass and the resonance circuit 1, and without having to deal with an AM modulation signal. This situation refers to the known power amplifier. The signalplots a-e represent respectively the voltage across the parallel RLC circuit, the current in the inductor L, the current at the capacitor C, the resonance circuit output voltage and the excitation signal. The switch in open state represents a resistance of 10K Ohm and in closed state 0 Ohm. As in the prior art situation the duty cycle of the excitation signal is chosen at 50%. The switch therewith connects the resonance circuit 1 to mass periodically over a full half cycle period. In this mode of operation an efficiency is obtained of approximately 45%, which very much corresponds to the efficiency achieved with the prior art power amplifier cited here above.

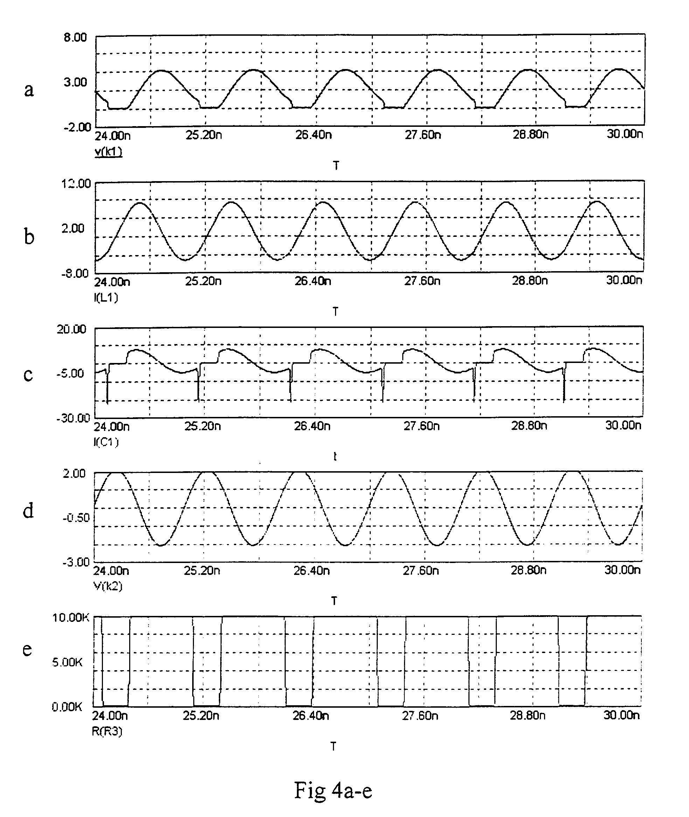

Figures 4a-e shows the variation over time of signals measured at the same points in the power amplifier of Figure 1 as in Figures 3a-e, again when using said MOS transistor as a switch in the excitation circuit 3, however, now with an excitation signal having a duty cycle of 25%. It appears that in steady state operation, the excitation of the the resonance circuit 1 sets the resonance mode such, that the excitation more or less automatically occurs at sinoidal resonance signal peak value. The efficiency obtained at this 25% duty cycle of the excitation signal now amounts to 85%. Furthermore, signal plot 4d clearly shows that the output signal to be transmitted does not necessitate to use a extra selective bandpass filter such as needed in the cited prior art power amplifier.

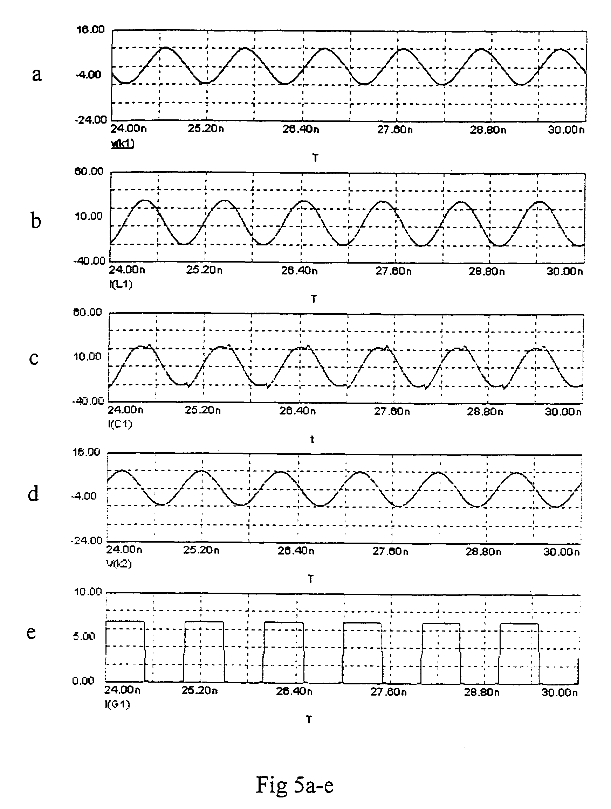

Figures 5a-e show the variation over time of signals measured at the same points in the power amplifier of Figure 1 as in Figures 3a-e, when using a charge pump with a bipolar output transistor having its collector-emitter path serially connected between mass and the resonance circuit 1. Also here AM modulations are not being dealt with, meaning that the supply voltage is constant as well as the envelope amplitude of the excitation signal. To show the improvement over the prior art situation achieved by the use of a charge pump the duty cycle of the excitation signal is chosen to be 50%. The efficiency appears to be 64%.

Unlike the situation of Figures 3a-e and 4a-d, the excitation signal now comprises pulses with gradually varying signal transients. In practise this very much simplifies the implementation of the power amplifier compared with the cited known power amplifier, in which complicated measures are taken to shorten signal transients.

The effect of the excitation on the current supplied to the capacitor C of the resonance circuit is shown in Figure 5c in the form of a small ripple on the curve.

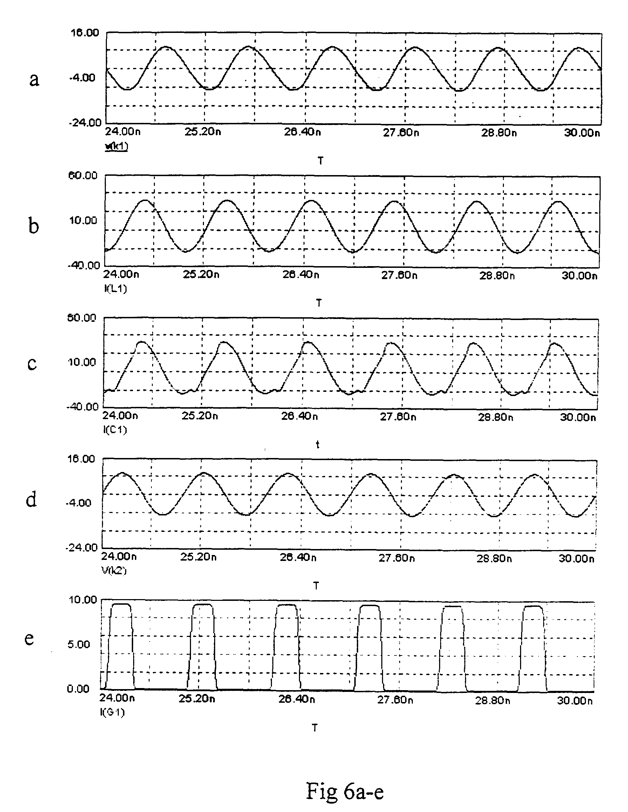

Figures 6a-e show the variation over time of signals measured at the same points in the power amplifier of Figure 1 as in Figures 5a-e, i.e. when using a charge pump with a bipolar output transistor having its collector-emitter path serially connected between mass and the resonance circuit 1. The duty cycle of the excitation signal is now chosen at 25%, which immediately shows a fundamental increase of the efficiency to 93%. The effect of the excitation on the current supplied to the capacitor C of the resonance circuit is shown in Figure 6c in the form of a small ripple on the curve. Compared with Figure 5c the ripple is somewhat extended due to the reduction in duty cycle and the concentration of supplied signal energy going along therewith.

Figures 7a-d show four various excitation signal forms a-d usable in a communication device according to the invention as shown in Figure 1 for the excitation current signal and usable in the communication device according to the invention as shown in Figure 2 for the variation of the inverse resistance value or conductancy value provided by the switching device or MOS transistor. Although some of these signal forms (e.g. signals a and d) may suggest to have a duty cycle exceeding 50%, the excitation effectively provided therewith is occurring in a duty cycle significantly less than 50%, because more than 50% of the signal energy occurs within a duty cycle substantially smaller than 50%. To avoid ambiguities the signal forms usable in applying the invention are defined to vary in their momentary amplitude between a minimum and a maximum level and exceeding 50% of the maximum current level (indicated with dotted lines) during a periodic time interval smaller than 50% of its repetition time.

Figure 8 a-c show signal plots illustrating the functioning of the power amplifier according to the invention when being used for amplifying an envelope amplitude modulated high frequency carrier signal with a digital AM baseband modulation signal as depicted in Figure 8b.

Figure 8a shows the result of AM modulation of an otherwise unmodulated (i.e. without PM and/or FM modulations) high frequency carrier signal obtained with the communication device of Figure 1 using a charge pump in the excitation circuit 3. In order to allow the resonance signal amplitude to vary with the AM modulation signal both excitation signal and supply voltage have to be amplitude modulated. The minimum voltage level occurring at the resonance circuit remains constant as shown in Figure 8a, whereas the transmitted antenna signal is varying symmetrically around zero level as is shown in Figure 8c.

When using the power amplifier of Figure 2 in which a switching device in the excitation circuit 3 is used, the excitation doesn't need to be varied and variation of the supply voltage with the AM baseband modulation signal suffices. This results again in the signals as shown in Figures 8a and 8c.

The possibility to arrive at a high frequency carrier transmitter signal being PM and/or FM modulated as well as AM modulated allows to use the communication devices according to the invention in telecommunication standard, such as e.g. CDMA. However, by keeping the envelope of the a high frequency carrier transmitter signal constant these communication devices may also be used in telecommunication standard such as e.g. GSM.

In a prototype power amplifier as shown in Figure 1 using a charge pump in the excitation circuit 3, the following relationships between the quality of the resonance circuit 1 and the duty cycle of the excitation signal used, were measured:

| | Q=2 | 4 | 6 | 8 | 10 |
|---|---|---|---|---|---|
| duty cycle = 50% | 68 | 67 | 66 | 65 | 64 |
| 45 % | 74 | 74 | 73 | 72 | 71 |
| 32 % | 85 | 88 | 88 | 88 | 86 |
| 25 % | 83 | 91 | 92 | 92 | 90 |
| 14 % | 70 | 85 | 91 | 93 | 93 |

Significant improvements in efficiency are obtained within the area defined by a quality factor greater than an order of magnitude of 2 and a duty cycle of the excitation signal less than an order of magnitude of 40%.

In the above the invention is explained with a voltage and current like excitation of the resonance circuit, bounding the area of characteristics of circuitry, which can be used to materialize the invention. It is clear that the invention may well be applied with any implementation of the excitation circuit 3 having a mixed current/voltage output characteristic.

The signal forms usable for an excitation in accordance with the invention are not limited to the ones shown in Figures 7a-d and include any form within the definition given in the claims which allow to realize an effective excitation of the resonance circuit occurring with a duty cycle less than 50%.

Furthermore, the invention does not preclude the use of an extra bandpass filter following the resonance circuit 1.

Additionally, taking into account the above differences with regard to the handling of amplitude modulations, the excitation circuit of Figure 1 may well be replaced by the excitation circuit of Figure 2 and vice versa.

## Claims

1. A communication device including a power amplifier for amplifying a modulated high frequency carrier input signal comprising a resonance circuit arranged between resonance circuit input means and antenna means characterized in that the resonance circuit input means comprise an excitation circuit for a periodic excitation of the resonance circuit phase and/or frequency coupled with the modulated high frequency carrier signal and substantially occurring with a duty cycle less than 50%.

2. A communication device according to claim 1, characterized in that the excitation circuit comprises a charge pump supplying an excitation current signal, phase and/or frequency coupled with the modulated carrier signal circuit having continuous transients between a minimum and a maximum current level, the excitation current signal exceeding 50% of the maximum current level during a periodic time interval smaller than 50% of the repetition time of the input signal.

3. A communication device according to claim 2, characterized in that an output stage of the charge pump comprises a bipolar transistor, the collector emitter path thereof being serially coupled to the resonance circuit between first and second terminals of a supply voltage source.

4. A communication device according to claim 2 or 3, characterized by amplitude modulation means for modulating the excitation signal as well as a supply voltage coupled to the resonance circuit with modulation signal dependent envelope amplitude variations of the modulated high frequency carrier signal.

5. A communication device according to one of claims 2 to 4, characterized in that the resonance circuit input means comprise a pulse generator controlling the excitation circuit to modulate the excitation signal in its phase and/or frequency and/or envelope amplitude in correspondence with the modulated high frequency carrier signal.

6. A communication device according to claims 2, 3 or 5, characterized in that the maximum level of the excitation signal is substantially constant.

7. A communication device according to claim 1, characterized in that the excitation circuit comprises a controllable switching device serially arranged with the resonance circuit between first and second terminals of a voltage supply source and having a control terminal coupled to the input of the power amplifier for periodically supplying an excitation voltage signal to the resonance circuit, phase and/or frequency coupled with the modulated carrier signal circuit with a duty cycle less than 50%.

8. A communication device according to claim 7, characterized in that the controllable switching device comprises a switch resistance serially arranged with the resonance circuit between the first and second terminals of said voltage supply source and being varied from a maximum resistance value to a minimum resistance value and vice versa and being smaller than 50% of the maximum resistance value during a periodic time interval smaller than 50% of the repetition time of the input signal.

9. A communication device according to claim 8, characterized in that the controllable switching device comprises a MOS transistor having its drain source path serially coupled to the resonance circuit being controlled to vary the switch resistance stepwise.

10. A communication device according to one of claims 7 to 9, characterized by amplitude modulation means for modulating the amplitude of the supply voltage between the first and second terminals of the voltage supply source with modulation signal dependent envelope amplitude variations of the modulated high frequency carrier signal.

11. A communication device according to one of claims 1 to 10, characterized by the resonance circuit having a resonance filter quality factor greater than 1.

12. A communication device according to one of claims 1 to 11, characterized in that said duty cycle is at most in the order of magnitude of 40% and the quality factor of the resonance circuit is greater than 2.

13. A communication device according to one of claims 1 to 12, characterized by a balanced implementation of the excitation circuit and the resonance circuit.

14. A communication device according to one of claims 1 to 13 characterized by said antenna means having narrow bandwidth and being part of the resonance circuit.

15. A communication device according to one of claims 1 to 14 characterized in that the resonance circuit comprises a parallel RLC circuit comprising an inductor provided with a tapped coupling to the antenna impedance.

16. A communication device according to claim 15, characterized in that the inductor is provided with a further tap, coupled to the excitation circuit.

17. High frequency power amplifier for use in a communication device according to one of claims 1 to 16, characterized by a resonance circuit part provided with antenna coupling means for completing the resonance circuit part to form said resonance circuit by coupling antenna means thereto.
